# EUROPEAN PATENT APPLICATION

(11) **EP 4 800 399 A1**
(43) Date of publication of application: **02.09.2026**
(21) Application number: 24887331.7
(22) Date of filing: 17.05.2024
(51) Int. Cl.: G01R 1/04, H01M 10/42, G01R 31/385, B25B 5/02, B25B 5/06, B25B 11/02, B65G 47/22, B65G 47/74, H01M 10/04

(54) **TEST TRAY AND BATTERY PRODUCTION DEVICE**

(30) Priority: 06.11.2023 CN 202311466040
(71) Applicant: Contemporary Amperex Technology Co., Limited, Ningde, Fujian 352100 (CN); Contemporary Amperex Runzhi Software Technology Limited, Ningde, Fujian 352100 (CN)
(72) Inventor: WEI, Guojie, Ningde, Fujian 352100 (CN)
(74) Representative: Ziebig Hengelhaupt Intellectual Property Attorneys Patentanwaltskanzlei PartGmbB
(86) International application number: PCT/CN2024/093934
(87) International publication number: WO 2025/097707

(57) **Abstract**

The present application discloses a test tray and a battery production device. The test tray comprises a tray main body, two sets of clamp assemblies and two squeezing members. The two sets of clamp assemblies are arranged spaced apart along a first direction, the clamp assemblies being disposed on the tray main body and able to move along the first direction, and being used for clamping a battery cell. The two squeezing members are arranged spaced apart along a second direction, the squeezing members being on the tray main body, and each squeezing member comprising a flexible squeezing portion, the flexible squeezing portion being used to contact the battery cell, so as to squeeze the battery cell, and the second direction intersecting with the first direction. The test tray provided in the embodiments of the present application can serve as a test tray for battery cells of different sizes. Therefore, even if the model of the battery cell is changed, additional replacement parts are not required, which can improve testing efficiency.

## Description

### CROSS-REFERENCE TO RELATED APPLICATION

The present application claims priority to Chinese Patent Application No. 202311466040.0 filed on November 6, 2023 and entitled "TEST TRAY AND BATTERY PRODUCTION DEVICE", the content of which is incorporated herein by reference in its entirety.

### TECHNICAL FIELD

The present application relates to the technical field of batteries, and in particular, to a test tray and a battery production device.

### BACKGROUND

Battery cells are widely used in electronic devices, such as mobile phones, laptop computers, electric bicycles, electric vehicles, electric airplanes, electric ships, electric toy cars, electric toy ships, electric toy airplanes, and electric tools. Battery cells may include nickelcadmium battery cells, nickel-hydrogen battery cells, lithium-ion battery cells, secondary alkaline zinc-manganese battery cells, and the like.

In the development of battery technologies, how to improve the test efficiency of battery production devices is a research direction in battery technologies.

### SUMMARY

Embodiments of the present application provide a test tray and a battery production device, which can improve the test efficiency of the battery production device.

In a first aspect, the embodiments of the present application provide a test tray. The test tray includes a tray body, two sets of clamp assemblies, and two compressing bodies. The two sets of clamp assemblies are spaced apart from each other in a first direction, and the clamp assemblies are movably disposed on the tray body in the first direction to clamp a battery cell. The two compressing bodies are spaced apart from each other in a second direction, and the compressing bodies are disposed on the tray body; each of the compressing bodies includes a flexible compressing part, and the flexible compressing part is configured to be in contact with the battery cell to compress the battery cell. The second direction intersects with the first direction.

In the above solution, the tray body is provided with the two compressing bodies spaced apart from each other in the second direction. When the test tray is used, the battery cell is placed between the two compressing bodies, and the flexible stock parts on the compressing bodies come into contact with the battery cell and compress the battery cell, so as to perform tests on processes such as formation. Since the two sets of clamp assemblies are movable in the first direction and are capable of clamping the battery cell, the test tray according to the embodiments of the present application can be used as a test tray for battery cells of different dimensions. Even if the model of the battery cell is changed, no additional components or parts need to be changed, thereby improving the test efficiency.

In some embodiments, the compressing body includes at least one deformable bladder. At least a portion of the bladder is formed as the flexible compressing part, and the structure is simple. The adjustment of a medium in the bladder helps to control the deformable amount of the flexible compressing part.

In some embodiments, the tray body includes a bottom plate and two side plates spaced apart from each other in the second direction, the side plates are movably connected to the bottom plate in the second direction, and the compressing body is disposed on the side plate.

In the above solution, since the side plate is movable relative to the bottom plate in the second direction, the spacing between the two side plates can also be adjusted, which can not only apply to battery cells of different lengths, but also apply to battery cells of different thicknesses, thereby further expanding the application range of the test tray.

In some embodiments, each of the side plates is provided with a first strip-shaped hole in the first direction; the tray body further includes an adjusting member, two ends of the adjusting member respectively pass through the first strip-shaped holes and are fixed to the side plates, and the clamp assembly is connected to the adjusting member.

In the above solution, by moving the adjusting member along the first strip-shaped hole, the position of the clamp assembly can be moved to adapt to battery cells of different dimensions. According to the embodiments of the present application, the structure is simple, which can facilitate the adjustment of the position of the clamp assembly, thereby further improving the test efficiency.

In some embodiments, the adjusting member includes an adjusting rod, a fixing post, a locking member, and an equal-height post. Two ends of the adjusting rod respectively pass through the first strip-shaped holes; the fixing post sleeves an outer periphery of the adjusting rod, where the fixing post is located on a side, facing the compressing body, of the side plate; the locking member is configured to lock the adjusting rod to the side plate, and the locking member is located on a side, facing away from the compressing body, of the side plate; two ends of the equal-height post in the second direction abut against the two side plates, respectively.

In the above solution, by adjusting the position of the fixing post, the length of the adjusting rod between the two side plates can be adjusted, such that the distance between the two side plates can be adjusted. By providing the equal-height post between the two side plates, the two clamping plates can be prevented from moving toward each other. Through the cooperation between the equal-height post, the fixing post, and the locking member, the purpose of quickly replacing battery cells of different dimensions can be achieved.

In some embodiments, the clamp assembly includes two battery brackets spaced apart from each other in the second direction, and the two battery brackets are movably connected to the adjusting member in the second direction.

In the above solution, by adjusting the spacing between the two battery brackets in the second direction, it is possible to more flexibly adapt to the test for battery cells of different thicknesses.

In some embodiments, each of the battery brackets includes a plate body, a hook part, and an elastic part. The plate body is provided with a clearance groove; the hook part is disposed on the plate body, and the hook part is connected to the adjusting member; the elastic part is connected to the plate body, and the elastic part is configured to abut against the adjusting member and is located in the clearance groove.

In the above solution, when the battery bracket is mounted on the adjusting member, it is only necessary to clamp the hook part of the battery bracket on the adjusting member, and the elastic part can deform to abut against the adjusting member, thereby facilitating the disassembly and assembly of the battery bracket.

In some embodiments, the side plate includes a side plate body and a first protruding part. The first protruding part is provided in a protruding manner from the side plate body along a third direction, and the first protruding part and the side plate body define, in an enclosing manner, a first groove. The third direction intersects with the first direction and the second direction. The bottom plate includes a bottom plate body and a second protruding part, the second protruding part is provided in a protruding manner relative to the bottom plate body in the second direction, the second protruding part and the bottom plate body define, in an enclosing manner, a second groove, the first protruding part is inserted into the second groove, and the second protruding part is inserted into the first groove.

In the above solution, through the cooperation between the first protruding part of the side plate and the second groove of the bottom plate, and the cooperation between the first groove of the side plate and the second protruding part of the bottom plate, the positioning of the bottom plate and the side plate can be facilitated, thereby improving the assembly efficiency.

In some embodiments, the bottom plate is provided with a second strip-shaped hole extending in the second direction, and the side plate is fixed to the bottom plate through the second strip-shaped hole.

By providing the second strip-shaped hole, the fixing position of the side plate and the bottom plate can be changed in the second direction. The fixing method is simple, and the purpose of quickly replacing battery cells of different dimensions can be achieved.

In some embodiments, the bottom plate is further provided with a third strip-shaped hole extending in the second direction, and the clamp assembly is fixed to the bottom plate through the third strip-shaped hole.

In the above solution, the fixing position of the clamp assembly and the bottom plate can be adjusted through the third strip-shaped hole, such that the purpose of quickly replacing battery cells of different dimensions can be achieved.

In some embodiments, the tray body further includes an elevation part, the elevation part includes a plurality of cushion blocks sequentially arranged along the third direction, and the cushion blocks are configured to support the battery cell. The third direction intersects with the first direction and the second direction.

In the above solution, tests can be performed on battery cells of different heights, thereby further expanding the application range of the test tray.

In some embodiments, the clamp assembly is provided with a mounting groove, and an end portion, in the first direction, of the elevation part is fixed in the mounting groove.

In the above solution, the clamp assembly is provided with the mounting groove for fixing the end portion of the elevation part, which can not only improve the stability of the elevation part, but also reduce the dimension of the test tray.

In some embodiments, the tray body further includes an elevation post, the clamp assembly is provided with a fixing hole for the elevation post to pass through, and the elevation post is configured to support the elevation part.

The elevation post supports the elevation part after passing through the fixing hole, such that the position of the elevation part can be finely adjusted, which allows tests on battery cells of different heights.

In some embodiments, the tray body further includes a limiting block disposed on the compressing body, and the clamp assembly is fixed to the compressing body by the limiting block.

In the above solution, by fixing through the limiting block, the stability of the clamp assembly and the compressing body can be improved, thereby improving the reliability of the entire test tray.

In some embodiments, the clamp assembly is provided with a plurality of first limiting holes in the first direction, and the limiting block is provided with second limiting holes corresponding to the first limiting holes.

By aligning the second limiting holes of the limiting block with different first limiting holes, the position of the clamp assembly in the first direction can be adjusted, which can not only improve the connection stability between the clamp assembly and the compressing body, but also achieve the purpose of quickly replacing battery cells of different dimensions.

In a second aspect, the embodiments of the present application provide a battery production device. The battery production device includes the test tray according to any one of the above embodiments.

The above description is only an overview of the technical solutions of the present application. To more clearly understand the technical means of the present application to enable implementation in accordance with the content of the specification and to make the features and advantages of the present application more obvious and easy to understand, the detailed description of the present application is provided below.

### BRIEF DESCRIPTION OF THE DRAWINGS

To more clearly illustrate the technical solutions according to embodiments of the present application, the drawings required for illustrating the embodiments of the present application are briefly described below. Apparently, the drawings in the following description illustrate merely some embodiments of the present application, and those of ordinary skill in the art may still derive other drawings from these drawings without creative efforts.
FIG. 1 is a schematic structural diagram of a test tray according to some embodiments of the present application;
FIG. 2 is a schematic structural diagram of a compressing body according to some embodiments of the present application;
FIG. 3 is a schematic structural diagram of a test tray according to some other embodiments of the present application;
FIG. 4 is a schematic diagram of part of a structure of a test tray according to some embodiments of the present application;
FIG. 5 is an enlarged schematic view of a portion A in FIG. 4;
FIG. 6 is a schematic structural diagram of a side plate and a bottom plate according to some embodiments of the present application;
FIG. 7 is a schematic diagram of part of a structure of a test tray according to some embodiments of the present application;
FIG. 8 is a schematic diagram of part of a structure of a test tray according to some embodiments of the present application;
FIG. 9 is a schematic structural diagram of a test tray according to some other embodiments of the present application; and
FIG. 10 is an enlarged schematic view of a portion B in FIG. 9.

The reference numerals are as follows:
100: test tray; 10: tray body; 11: bottom plate; 111: bottom plate body; 112: second protruding part; 113: second groove; 114: second strip-shaped hole; 115: third strip-shaped hole; 12: side plate; 121: first strip-shaped hole; 122: side plate body; 123: first protruding part; 124: first groove; 13: limiting block; 131: second limiting hole; 20: clamp assembly; 21: battery bracket; 211: plate body; 212: hook part; 213: elastic part; 214: clearance groove; 215: connecting end; 216: free end; 22: mounting groove; 23: first limiting hole; 30: compressing body; 31: flexible compressing part; 32: frame body; 33: flexible cover; 40: adjusting member; 41: adjusting rod; 42: fixing post; 43: locking member; 50: elevation part; 51: cushion block; 200: battery cell; X: first direction; Y: second direction; Z: third direction.

### DETAILED DESCRIPTION

Implementations of the present application will be described in further detail with reference to the drawings and embodiments. The following detailed description of the embodiments and the drawings are used for the exemplary illustration of the principles of the present application, but are not intended to limit the scope of the present application. That is, the present application is not limited to the described embodiments.

In the description of the present application, it should be noted that unless otherwise specified, "plurality of" means two or more; the orientations or positional relationships indicated by the terms "upper", "lower", "left", "right", "inner", "outer", and the like are merely for the convenience of describing the present application and simplifying the description, rather than indicating or implying that the apparatus or element referred to must have a specific orientation or be constructed and operated in the specific orientation, and thus should not be construed as a limitation to the present application. Furthermore, the terms "first", "second", "third", and the like are used for descriptive purposes only and should not be construed as indicating or implying relative importance. The "perpendicular" is not strictly perpendicular but is within the allowable range of error. The "parallel" is not strictly parallel but is within the allowable range of error.

Reference in the present application to "embodiment" means that a particular feature, structure, or characteristic described in connection with the embodiment can be included in at least one embodiment of the present application. The references of the word in the context of the specification do not necessarily refer to the same embodiment, nor to separate or alternative embodiments exclusive of other embodiments. It will be explicitly and implicitly understood by those skilled in the art that the described embodiments of the present application can be combined with other embodiments.

The following description is given with the directional terms as shown in the drawings and is not intended to limit the specific structure of the present application. In the description of the present application, it should further be noted that unless otherwise explicitly specified or defined, the terms "mount", "interconnect", and "connect" shall be construed broadly and may be, for example, fixed connection, detachable connection, or integral connection, or direct connection or indirect connection via an intermediate. For those of ordinary skill in the art, the specific meaning of the above terms in the present application may be interpreted according to the specific condition.

Battery cells may include lithium-ion secondary batteries, lithium-ion primary batteries, lithium-sulfur batteries, sodium-lithium-ion batteries, sodium-ion batteries, magnesium-ion batteries, or the like. A battery cell includes an electrode assembly and an electrolytic solution. The electrode assembly is composed of a positive electrode plate, a negative electrode plate, and a separator. The battery cell primarily works by the movement of metal ions between the positive electrode plate and the negative electrode plate. The positive electrode plate includes a positive electrode current collector and a positive electrode active substance layer. The surface of the positive electrode current collector is coated with the positive electrode active substance layer. The current collector not coated with the positive electrode active substance layer protrudes from the current collector coated with the positive electrode active substance layer. The current collector not coated with the positive electrode active substance layer is stacked and serves as a positive electrode tab. Taking lithium-ion batteries as an example, the material of the positive electrode current collector may be aluminum, and the positive electrode active substance may be lithium cobaltate, lithium iron phosphate, ternary lithium, lithium manganate, or the like. The negative electrode plate includes a negative electrode current collector and a negative electrode active substance layer. The surface of the negative electrode current collector is coated with the negative electrode active substance layer. The current collector not coated with the negative electrode active substance layer protrudes from the current collector coated with the negative electrode active substance layer. The current collector not coated with the negative electrode active substance layer is stacked and serves as a negative electrode tab. The material of the negative electrode current collector may be copper, and the negative electrode active substance may be carbon, silicon, or the like. The material of the separator may be polypropylene (PP), polyethylene (PE), or the like.

In the production process of battery cells, the formation process is a very important step. The formation is mainly the process of charging the battery cells for the first time, so as to activate the battery cells. In this process, the solvent and the lithium salt in the electrolytic solution undergo side reactions, resulting in the formation of a solid electrolyte phase interface film at the negative electrode of the battery cell. Meanwhile, the solvent and some additives in the electrolytic solution are reduced or decomposed, resulting in severe gas generation inside the battery cell. If the gas generated during the formation cannot be discharged in time, in one aspect, the battery will bulge, resulting in a decrease in group margin. As a result, the electrolytic solution in the battery cell cannot completely wet the negative electrode, and small dried-up black spots without lithium intercalation will be formed at positions that are not fully wet, resulting in lithium plating around the black spots. In another aspect, the lithium ions deintercalated from the positive electrode are prone to lithium plating around bubbles, thereby affecting the performance of the battery cell.

In order to alleviate the influence of gas on the battery cells, in the related art, the battery cells are fixed in a restraint tray during the formation process, and the battery cells in the restraint tray compress against each other to promote the gas generated inside the battery cells to be expelled from the battery cells. Due to the large dimension of the tray, the tray needs to be filled with battery cells before use, and the tray performance test evaluation in a laboratory cannot be performed for battery cells of different dimensions, thereby reducing the test efficiency of the battery production device.

In view of this, the present application provides a technical solution. In the technical solution, a test tray includes a tray body, two sets of clamp assemblies, and two compressing bodies. The two sets of clamp assemblies are spaced apart from each other in a first direction, and the clamp assemblies are movably disposed on the tray body in the first direction to clamp a battery cell. The two compressing bodies are spaced apart from each other in a second direction, and the compressing bodies are disposed on the tray body; each of the compressing bodies is provided with a flexible compressing part, and the flexible compressing part is configured to be in contact with the battery cell to compress the battery cell. The second direction intersects with the first direction.

In the above solution, the tray body is provided with the two compressing bodies spaced apart from each other in the second direction. When the test tray is used, the battery cell is placed between the two compressing bodies, and the flexible stock parts on the compressing bodies come into contact with the battery cell and compress the battery cell, so as to perform tests on processes such as formation. Since the two sets of clamp assemblies are movable in the first direction and are capable of clamping the battery cell, the test tray according to the embodiments of the present application can be used as a test tray for battery cells of different dimensions. Even if the model of the battery cell is changed, no additional components or parts need to be changed, thereby improving the test efficiency.

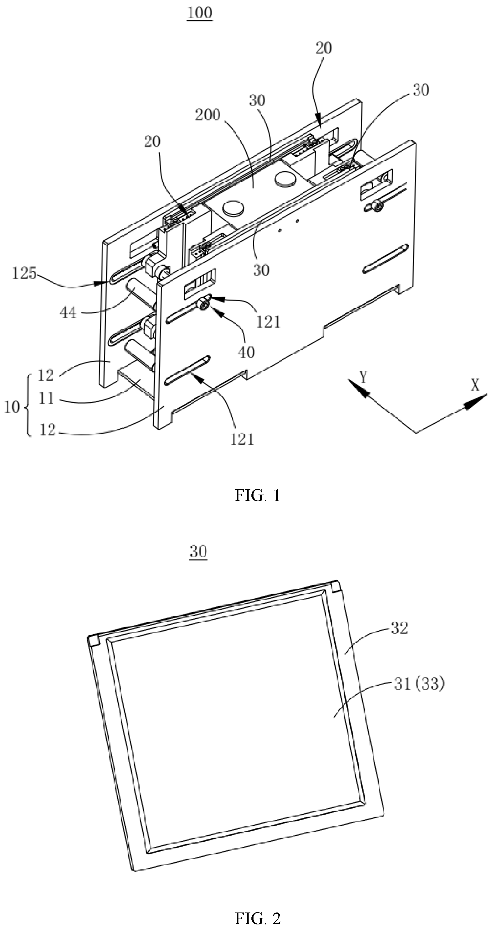

FIG. 1 is a schematic structural diagram of a test tray according to some embodiments of the present application; FIG. 2 is a schematic structural diagram of a compressing body according to some embodiments of the present application.

Referring to FIGs. 1 and 2, in a first aspect, the embodiments of the present application provide a test tray 100. The test tray 100 includes a tray body 10, two sets of clamp assemblies 20, and two compressing bodies 30. The two sets of clamp assemblies 20 are spaced apart from each other in a first direction X, and the clamp assemblies 20 are movably disposed on the tray body 10 in the first direction X to clamp a battery cell 200. The two compressing bodies 30 are spaced apart from each other in a second direction Y, and the compressing bodies 30 are disposed on the tray body 10; each of the compressing bodies 30 is provided with a flexible compressing part 31, and the flexible compressing part 31 is configured to be in contact with the battery cell 200 to compress the battery cell 200. The second direction Y intersects with the first direction X.

It should be noted that the test tray 100 according to the embodiments of the present application is not limited to a test tray 100 for a formation process, and is also applicable to a test tray 100 for a capacity test machine. Capacity test machines (also referred to as capacity testers or battery capacity test devices) are devices for evaluating capacity characteristics of a battery. They are generally used to measure the energy storage capacity of the battery under different charging and discharging conditions, that is, the amount of electrical energy that the battery can store and release. The capacity test machine charges a battery and records the amount of released charges by simulating the charging and discharging process in an actual use scenario, and thus the capacity of the battery is calculated. This helps to verify whether the battery meets the capacity standard specified by the manufacturer and evaluate whether the performance of the battery meets the expected requirements.

For ease of understanding, the following embodiments are illustrated and explained by taking an example where the test tray 100 is applied to a formation process.

The tray body 10 is a component configured to support the battery cell 200. The tray body 10 may be a U-shaped tray or a box tray. The tray body 10 may be integrally formed or may be assembled by splicing. The material of the tray body 10 may be, but is not limited to, metal, plastic, inorganic nonmetal, wood, or the like.

The compressing body 30 is a component configured to compress the battery cell 200, and the flexible compressing part 31 is a component that may deform after being subjected to a force. The compressing body 30 includes at least one deformable bladder, and at least a portion of the bladder is formed as the flexible compressing part 31. The bladder refers to a flexible container. A medium can flush into the flexible container, and elastic deformation can be achieved by utilizing the compressibility and/or fluidity of the medium. Here, the deformation of the bladder may be achieved by adjusting the amount of the medium flushing into the bladder, for example, the bladder may expand by inflation, and the bladder may contract by venting; the deformation may also be achieved by changing the state of the medium in the bladder, for example, the water in the bladder is vaporized by heating to cause the bladder to expand, and the vapor in the bladder is condensed by cooling to cause the bladder to contract. It should be noted that the medium may be a gaseous medium at room temperature, such as air, an inert gas, or nitrogen, and in this case, the bladder is a gas bladder; the medium may also be a liquid medium at room temperature, such as water or oil, and in this case, the bladder is a liquid bladder; or the medium may even be a solid medium at room temperature, such as paraffin, which melts into a liquid after heating. The structure of the bladder is simple, and the adjustment of the medium in the bladder helps to control the deformable amount of the flexible compressing part.

Specifically, the bladder includes a frame body 32 and a flexible cover 33. The frame body 32 is rigid, the flexible cover 33 covers at least one frame opening on the frame body 32, the frame body 32 and the flexible cover 33 define, in an enclosing manner, a bladder cavity, and the flexible cover 33 is formed as the flexible compressing part 31. The flexible cover 33 is a deformable component, and it is difficult for the medium to pass through the flexible cover. The material of the flexible cover 33 may be, but is not limited to, silica gel, cow leather, rubber, latex, or the like.

The clamp assembly 20 may be connected to the tray body 10 through a slide block, and may move in the first direction X by the driving of a driving mechanism or by the sliding of an adjusting member 40 relative to the tray body 10. The first direction X may be the length direction of the battery cell 200, and the second direction Y may be the thickness direction of the battery cell 200. When the test tray 100 is used, the battery cell 200 is placed between the two compressing bodies 30, and the spacing between the two clamp assemblies 20 in the first direction X may be adjusted according to the length of the battery cell 200, so as to clamp two opposite sides of the battery cell 200 in the first direction X. Then, the battery cell 200 is compressed by the compressing bodies 30 to test the compressing bodies 30. The test tray 100 according to the embodiments of the present application may be used to verify the test of the interface effect of the formation process, and may also be used to verify the parameters of the compressing body 30. Illustratively, when the bladder of the compressing body 30 is a gas bladder, the test tray may be used to verify the parameters such as the gas bladder pressure, the hardness of the flexible cover 33, the specific elongation, and the service life of the gas bladder of different battery cells 200.

In summary, in the embodiments of the present application, the tray body 10 is provided with the two compressing bodies 30 spaced apart from each other in the second direction Y. When the test tray 100 is used, the battery cell 200 is placed between the two compressing bodies 30, and the flexible stock parts on the compressing bodies 30 come into contact with the battery cell 200 and compress the battery cell 200, so as to perform tests on processes such as formation. Since the two sets of clamp assemblies 20 are movable in the first direction X and are capable of clamping the battery cell 200, the test tray 100 according to the embodiments of the present application can be used as a test tray 100 for battery cells 200 of different dimensions. Even if the model of the battery cell 200 is changed, no additional components or parts need to be changed, thereby improving the test efficiency.

In some embodiments, the tray body 10 includes a bottom plate 11 and two side plates 12 spaced apart from each other in the second direction Y, the side plates 12 are movably connected to the bottom plate 11 in the second direction Y, and the compressing body 30 is disposed on the side plate 12.

The compressing body 30 is disposed on a side, facing the battery cell 200, of the side plate 12, and the side plate 12 may be connected to the bottom plate 11 through a bolt. For example, the bottom plate 11 is provided with a plurality of bolt holes in the second direction Y, and then the corresponding bolt holes are selected according to the thickness of the battery cell 200 to connect the side plate 12. Alternatively, the bottom plate 11 is provided with a strip-shaped hole extending in the second direction Y, and the connection position of the side plate 12 in the strip-shaped hole may be adjusted according to the thickness of the battery cell 200. In addition, guide posts may be disposed on the bottom plate 11 in the second direction Y, and slide blocks may be disposed on the side plates 12, such that the spacing between the two side plates 12 is adjusted by the sliding of the slide blocks along the guide posts.

The bottom plate 12 may be a planar plate, an arc-shaped plate with a certain radian, or the like. The side plate 12 may be a planar plate, so as to adapt to the tests of square-shell batteries. Alternatively, the side plate 12 may also be curved, cup-shaped, or the like, so as to adapt to the tests of cylindrical batteries.

In the above solution, since the side plate 12 is movable relative to the bottom plate 11 in the second direction Y, the spacing between the two side plates 12 can also be adjusted, which can not only apply to battery cells 200 of different lengths, but also apply to battery cells 200 of different thicknesses, thereby further expanding the application range of the test tray 100.

In some embodiments, each of the side plates 12 is provided with a first strip-shaped hole 121 in the first direction X; the tray body 10 further includes an adjusting member 40, two ends of the adjusting member 40 respectively pass through the first strip-shaped holes 121 and are fixed to the side plates 12, and the clamp assembly 20 is connected to the adjusting member 40.

Each clamp assembly 20 may be connected to one or two adjusting members 40. For example, two first strip-shaped holes 121 are provided on the left end of each side plate 12, and two first strip-shaped holes 121 are also provided on the right end of each side plate. The first strip-shaped hole 121 may be an elongated strip-shaped elliptical hole or a rectangular hole.

In the above solution, by moving the adjusting member 40 along the first strip-shaped hole 121, the position of the clamp assembly 20 can be moved to adapt to battery cells 200 of different dimensions. According to the embodiments of the present application, the structure is simple, which can facilitate the adjustment of the position of the clamp assembly 20, thereby further improving the test efficiency.

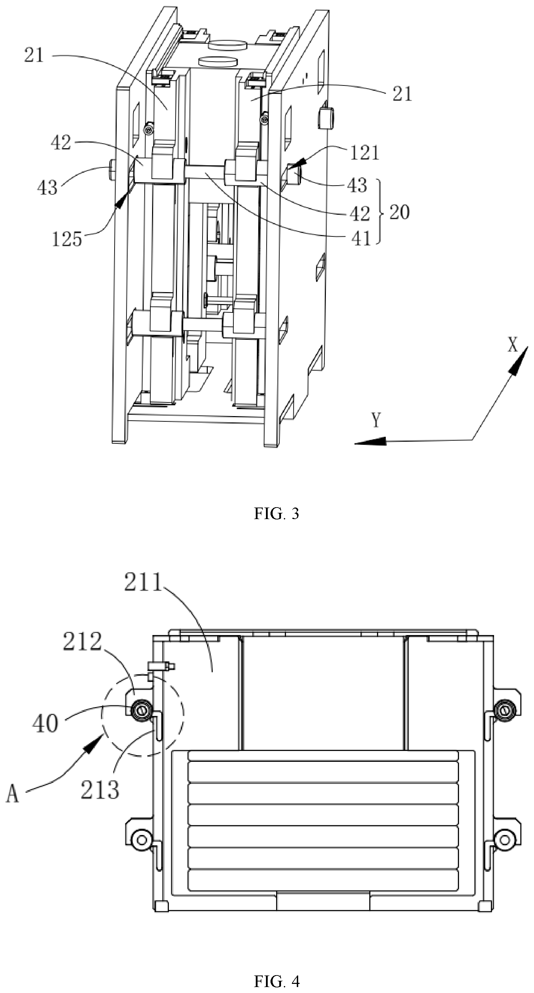

FIG. 1 is a schematic structural diagram of a test tray according to some embodiments of the present application; FIG. 3 is a schematic structural diagram of a test tray according to some other embodiments of the present application.

Referring to FIGs. 1 and 3, in some embodiments, the adjusting member 40 includes an adjusting rod 41, a fixing post 42, a locking member 43, and an equal-height post 44. Two ends of the adjusting rod 41 respectively pass through the first strip-shaped holes 121; the fixing post 42 sleeves the outer periphery of the adjusting rod 41, where the fixing post 42 is located on a side, facing the compressing body 30, of the side plate 12; the locking member 43 is configured to lock the adjusting rod 41 to the side plate 12, and the locking member 43 is located on a side, facing away from the compressing body 30, of the side plate 12.

The adjusting rod 41 passes through the fixing post 42 and the first strip-shaped hole 121. The fixing post 42 can sleeve the outer periphery of the adjusting rod 41 by interference fit, and the fixing post 42 can move along the adjusting rod 41, but there is a certain tensioning force between the fixing post 42 and the adjusting rod 41. The outer periphery of each adjusting rod 41 may be sleeved with two fixing posts 42, and the two fixing posts 42 abut against the two side plates 12 in one-to-one correspondence. The locking member 43 may be a bolt, and threads may be provided at the end portion of the adjusting rod 41, such that the adjusting rod 41 is fixed by a threaded connection. Alternatively, the locking member 43 is a snap, and the end portion of the adjusting rod 41 is fixed through a snap-fit connection.

When the test tray 100 is used, the side plate 12 may be moved according to the thickness of the battery cell 200, and then the fixing post 42 is slid to the side, facing the battery cell 200, of the side plate 12, such that the fixing post 42 abuts against the side plate 12, and then the adjusting rod 41 is locked by the locking member 43 at the side, facing away from the battery cell 200, of the side plate 12.

Two ends of the equal-height post 44 can abut against the two side plates 12 to prevent the two side plates 12 from moving close to each other, such that a certain spacing distance is maintained between the two side plates 12.

A limiting groove 125 may be provided on one side of the side plate 12 and in the circumferential direction of the first strip-shaped hole 121, and the fixing post 42 and the equal-height post 44 abut against the limiting groove 125, which is equivalent to that the end portion of the fixing post 42 and the end portion of the equal-height post 44 are located in the limiting groove 125, so as to limit the fixing post 42 and the equal-height post 44 and prevent the fixing post 42 and the equal-height post 44 from moving.

In the above solution, by adjusting the position of the fixing post 42, the length of the adjusting rod 41 between the two side plates 12 can be adjusted, such that the distance between the two side plates 12 can be adjusted. Through the cooperation between the fixing post 42 and the locking member 43, the purpose of quickly replacing battery cells 200 of different dimensions can be achieved.

In some embodiments, the clamp assembly 20 includes two battery brackets 21 spaced apart from each other in the second direction Y, and the two battery brackets 21 are movably connected to the adjusting member 40 in the second direction Y.

The battery brackets 21 may be connected to the adjusting member 40 by a snap-fit connection, a bolted connection, or the like. The spacing between the two battery brackets 21 may be adjusted by adjusting the connection positions of the battery brackets 21 on the adjusting member 40.

In the above solution, by adjusting the spacing between the two battery brackets 21 in the second direction Y, it is possible to more flexibly adapt to the test for battery cells 200 of different thicknesses.

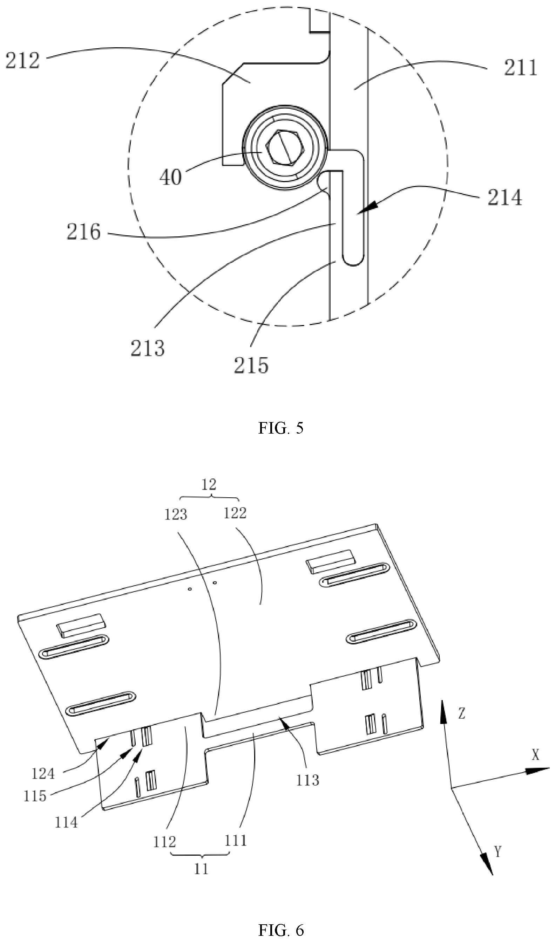

FIG. 4 is a schematic diagram of part of a structure of a test tray according to some embodiments of the present application; FIG. 5 is an enlarged schematic view of a portion A in FIG. 4.

Referring to FIGs. 4 and 5, in some embodiments, each of the battery brackets 21 includes a plate body 211, a hook part 212, and an elastic part 213. The plate body 211 is provided with a clearance groove 214; the hook part 212 is disposed on the plate body 211, and the hook part 212 is connected to the adjusting member 40; the elastic part 213 is connected to the plate body 211, and the elastic part 213 is configured to abut against the adjusting member 40 and is located in the clearance groove 214.

The battery bracket 21 may be an integrally formed part, or may be formed by assembling different parts. The hook part 212 is provided with a notch, which can cover part of the outer periphery of the adjusting member 40. The elastic part 213 may be made of plastic, stainless steel, or the like, and can deform to some extent. Alternatively, the entire battery bracket 21 is made of plastic, stainless steel, or other materials, and the elastic part 213 has a small thickness and thus is deformable.

The elastic part 213 is provided with a connecting end 215 and a free end 216, and the connecting end 215 of the elastic part 213 is connected to the plate body 211. When the battery bracket 21 needs to be assembled, the elastic part 213 may be pressed, such that the free end 216 of the elastic part 213 is bent close to the clearance groove 214; then the hook part 212 is hung to the outer periphery of the adjusting member 40; and then the elastic part 213 is released, and the elastic part 213 recovers from the deformation and abuts against the adjusting member 40, such that the battery bracket 21 is fixed to the adjusting member 40. When the battery bracket 21 needs to be detached, the elastic part 213 may also be pressed, such that the free end 216 of the elastic part 213 is bent close to the clearance groove 214; and then the plate body 211 is moved upward, such that the hook part 212 is disengaged from the adjusting member 40, and the battery bracket 21 can be taken out.

In the above solution, when the battery bracket 21 is mounted on the adjusting member 40, it is only necessary to clamp the hook part 212 of the battery bracket 21 on the adjusting member 40, and the elastic part 213 can deform to abut against the adjusting member 40, thereby facilitating the disassembly and assembly of the battery bracket 21.

FIG. 6 is a schematic structural diagram of a side plate and a bottom plate according to some embodiments of the present application.

As shown in FIG. 6, in some embodiments, the side plate 12 includes a side plate body 122 and a first protruding part 123. The first protruding part 123 is provided in a protruding manner from the side plate body 122 along a third direction Z, and the first protruding part 123 and the side plate body 122 define, in an enclosing manner, a first groove 124. The third direction Z intersects with the first direction X and the second direction Y. The bottom plate 11 includes a bottom plate body 111 and a second protruding part 112, the second protruding part 112 is provided in a protruding manner relative to the bottom plate body 111 in the second direction Y, the second protruding part 112 and the bottom plate body 111 define, in an enclosing manner, a second groove 113, the first protruding part 123 is inserted into the second groove 113, and the second protruding part 112 is inserted into the first groove 124.

Illustratively, the first protruding part 123 is located at the lower end of the side plate body 122, and the first groove 124 is located next to the first protruding part 123. The left side and the right side of the bottom plate 11 are each provided with a second protruding part 112, and the second groove 113 is located between the two second protruding parts 112.

The dimension of the first protruding part 123 may match the dimension of the second groove 113, such that the first protruding part 123 can move along the second groove 113. Similarly, the dimension of the second protruding part 112 may match the dimension of the first groove 124, such that the second protruding part 112 can move along the first groove 124.

In the above solution, through the cooperation between the first protruding part 123 of the side plate 12 and the second groove 113 of the bottom plate 11, and the cooperation between the first groove 124 of the side plate 12 and the second protruding part 112 of the bottom plate 11, the positioning of the bottom plate 11 and the side plate 12 can be facilitated, thereby improving the assembly efficiency.

In some embodiments, the bottom plate 11 is provided with a second strip-shaped hole 114 extending in the second direction Y, and the side plate 12 is fixed to the bottom plate 11 through the second strip-shaped hole 114.

The second strip-shaped hole 114 may be an elongated strip-shaped elliptical hole or a rectangular hole. A fixing hole may be provided at the bottom of the side plate 12, and a bolt is used to sequentially pass through the second strip-shaped hole 114 and the fixing hole of the side plate 12 to fix the bottom plate 11 and the side plate 12. In addition, the fixing position of the bolt may be adjusted along the second strip-shaped hole 114 according to the thickness of the battery cell 200. There may be a plurality of second strip-shaped holes 114. For example, second strip-shaped holes 114 are provided at the corners of the bottom plate 11, or at least two second strip-shaped holes 114 may be provided at each corner.

In the above solution, by providing the second strip-shaped hole 114, the fixing position of the side plate 12 and the bottom plate 11 can be changed in the second direction Y. The fixing method is simple, and the purpose of quickly replacing battery cells 200 of different dimensions can be achieved.

In some embodiments, the bottom plate 11 is further provided with a third strip-shaped hole 115 extending in the second direction Y, and the clamp assembly 20 is fixed to the bottom plate 11 through the third strip-shaped hole 115.

The second strip-shaped hole 114 and the third strip-shaped hole 115 may be parallel to each other and spaced apart from each other. The third strip-shaped hole 115 may be an elongated strip-shaped elliptical hole or a rectangular hole. A fixing hole may be provided at the bottom of the clamp assembly 20, and a bolt is used to sequentially pass through the third strip-shaped hole 115 and the fixing hole of the clamp assembly 20 to fix the bottom plate 11 to the clamp assembly 20. In addition, the fixing position of the bolt may be adjusted along the third strip-shaped hole 115 according to the thickness of the battery cell 200. There may be a plurality of third strip-shaped holes 115. For example, third strip-shaped holes 115 are provided at the corners of the bottom plate 11.

In the above solution, the fixing position of the clamp assembly 20 and the bottom plate 11 can be adjusted through the third strip-shaped hole 115, such that the purpose of quickly replacing battery cells 200 of different dimensions can be achieved.

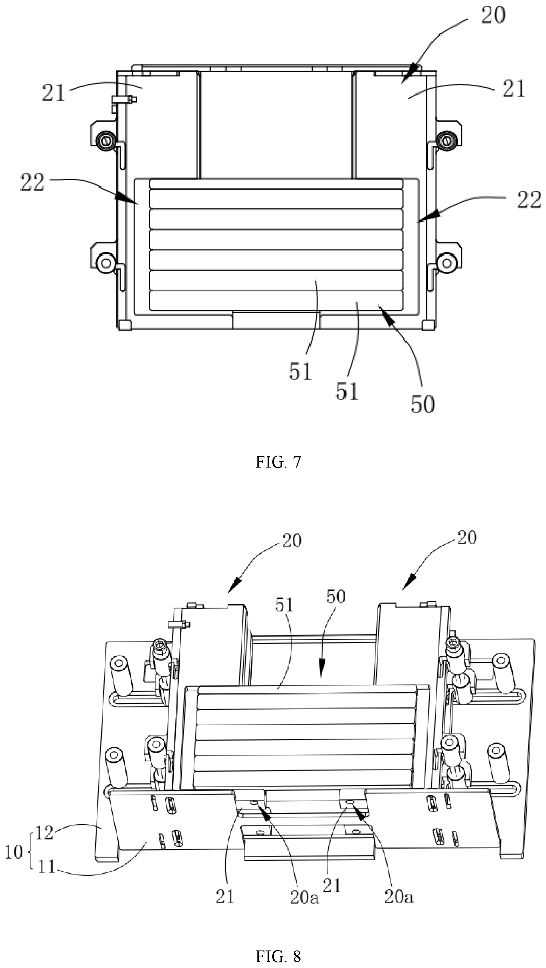

FIG. 7 is a schematic diagram of part of a structure of a test tray according to some embodiments of the present application.

As shown in FIG. 7, in some embodiments, the tray body 10 further includes an elevation part 50, the elevation part 50 includes a plurality of cushion blocks 51 sequentially arranged along the third direction Z, and the cushion blocks 51 are configured to support the battery cell 200. The third direction Z intersects with the first direction X and the second direction Y.

The cushion block 51 may extend in the first direction X and be in a rectangular parallelepiped shape. The elevation part 50 may be disposed on the side, facing the battery cell 200, of the compressing body 30. During the test, the battery cell 200 may be placed on the upper side of the elevation part 50, that is, the battery cell 200 is in contact with the cushion block 51 located at the uppermost end. When the battery cells 200 of different heights need to be replaced, it is only necessary to reduce or increase the number of the cushion blocks 51, such that the battery cells 200 can be completely located between the two flexible compressing parts 31.

In the above solution, tests can be performed on battery cells 200 of different heights, thereby further expanding the application range of the test tray 100.

In some embodiments, the clamp assembly 20 is provided with a mounting groove 22, and the end portion, in the first direction X, of the elevation part 50 is fixed in the mounting groove 22.

The mounting groove 22 may be provided on the side, facing the side plate 12, of the clamp assembly 20. Specifically, the side, facing the side plate 12, of the plate body 211 of the battery bracket 21 may be recessed to form the mounting groove 22. Two ends of the elevation part 50 are located in the mounting groove 22, and the two ends of the elevation part 50 are clamped between the compressing body 30 and the clamp assembly 20.

In the above solution, the clamp assembly 20 is provided with the mounting groove 22 for fixing the end portion of the elevation part 50, which can not only improve the stability of the elevation part 50, but also reduce the dimension of the test tray 100.

FIG. 8 is a schematic diagram of part of a structure of a test tray according to some embodiments of the present application.

As shown in FIG. 8, the tray body 10 further includes an elevation post (not shown in the figure), the clamp assembly 20 is provided with a fixing hole 20a for the elevation post to pass through, and the elevation post is configured to support the elevation part 50.

The fixing hole 20a may be provided at the bottom of the battery bracket 21, the fixing hole 20a may be a threaded hole, and the elevation post may be a bolt. After the elevation post passes through the fixing hole 20a, the elevation part 50 may be raised or lowered by adjusting the position of the elevation post up and down.

In the embodiments of the present application, the elevation post supports the elevation part 50 after passing through the fixing hole 20a, such that the position of the elevation part 50 can be finely adjusted, which allows tests on battery cells 20 of different heights.

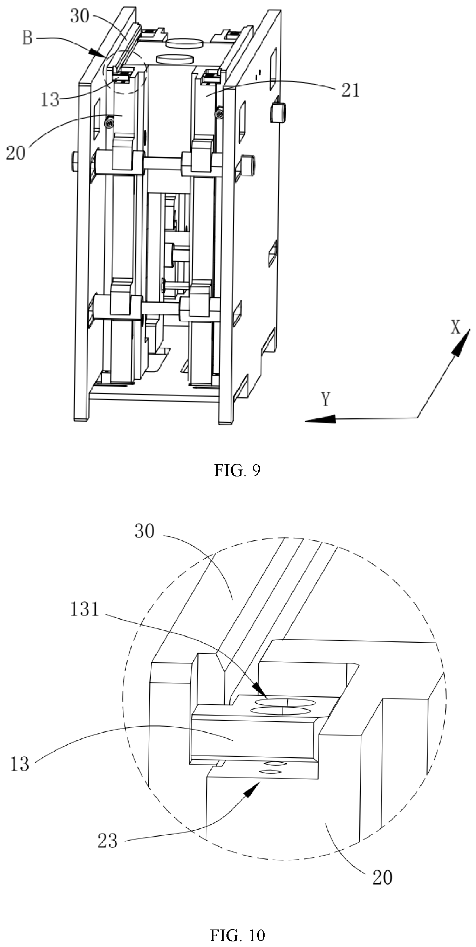

FIG. 9 is a schematic structural diagram of a test tray according to some other embodiments of the present application.

As shown in FIG. 9, in some embodiments, the tray body 10 further includes a limiting block 13 disposed on the compressing body 30, and the clamp assembly 20 is fixed to the compressing body 30 by the limiting block 13.

The limiting block 13 may be disposed at the corner of the compressing body 30. For example, a snap groove is disposed at the corner of the compressing body 30, the limiting block 13 is accommodated in the snap groove, and the limiting block 13 may be fixed to the compressing body 30 by a bolted connection, a bonding connection, a welding connection, or the like. The limiting block 13 may be fixed to the clamp assembly 20 by a bolted connection, a snap-fit connection, or the like.

In the above solution, by fixing through the limiting block 13, the stability of the clamp assembly 20 and the compressing body 30 can be improved, thereby improving the reliability of the entire test tray 100.

FIG. 10 is an enlarged schematic view of a portion B in FIG. 9. As shown in FIG. 10, in some embodiments, the clamp assembly 20 is provided with a plurality of first limiting holes 23 in the first direction X, and the limiting block 13 is provided with second limiting holes 131 corresponding to the first limiting holes 23.

Illustratively, the limiting block 13 is provided with two second limiting holes 131. When the clamp assembly 20 needs to be adjusted to adapt to battery cells 200 of different lengths, the clamp assembly 20 may be moved to align the second limiting holes 131 on the limiting block 13 with the corresponding first limiting holes 23, and then the limiting block 13 is locked to the clamp assembly 20 by bolts or the like sequentially passing through the second limiting holes 131 and the first limiting holes 23.

In the above solution, by aligning the second limiting holes 131 of the limiting block 13 with different first limiting holes 23, the position of the clamp assembly 20 in the first direction X can be adjusted, which can not only improve the connection stability between the clamp assembly 20 and the compressing body 30, but also achieve the purpose of quickly replacing battery cells 200 of different dimensions.

In a second aspect, the embodiments of the present application provide a battery production device. The battery production device includes the test tray 100 according to any one of the above embodiments.

According to some embodiments of the present application, the present application provides a test tray 100. The test tray 100 includes a tray body 10, two sets of clamp assemblies 20, and two compressing bodies 30. The two sets of clamp assemblies 20 are spaced apart from each other in a first direction X, and the clamp assemblies 20 are movably disposed on the tray body 10 in the first direction X to clamp a battery cell 200. The two compressing bodies 30 are spaced apart from each other in a second direction Y, and the compressing bodies 30 are disposed on the tray body 10; each of the compressing bodies 30 is provided with a flexible compressing part 31, and the flexible compressing part 31 is configured to be in contact with the battery cell 200 to compress the battery cell 200. The second direction Y intersects with the first direction X. The tray body 10 includes a bottom plate 11 and two side plates 12 spaced apart from each other in the second direction Y, the side plates 12 are movably connected to the bottom plate 11 in the second direction Y, and the compressing body 30 is disposed on the side plate 12.

Finally, it should be noted that the above embodiments are only used to illustrate the technical solutions of the present application, rather than limit the same. Although the present application has been described in detail with reference to the foregoing embodiments, those of ordinary skill in the art should understand that modifications can still be made to the technical solutions recorded in the foregoing embodiments, or equivalent substitutions to some or all of the technical features can be made. However, such modifications or substitutions do not make the spirit of the corresponding technical solutions deviate from the scope of the technical solutions in the embodiments of the present application, and shall all fall within the scope of the claims and specification of the present application. In particular, the technical features mentioned in the embodiments can be combined in any manner, provided that there is no structural conflict. The present application is not limited to the specific embodiments disclosed herein, but encompasses all technical solutions falling within the scope of the claims.

## Claims

1. A test tray, comprising:
a tray body;
two sets of clamp assemblies, wherein the two sets of clamp assemblies are spaced apart from each other in a first direction, and the clamp assemblies are movably disposed on the tray body in the first direction and configured to clamp a battery cell; and
two compressing bodies, wherein the two compressing bodies are spaced apart from each other in a second direction, and the compressing bodies are disposed on the tray body; each of the compressing bodies comprises a flexible compressing part, and the flexible compressing part is configured to be in contact with the battery cell to compress the battery cell, the second direction intersecting with the first direction.

2. The test tray according to claim 1, wherein the compressing body comprises at least one deformable bladder, and at least a portion of the bladder is formed as the flexible compressing part.

3. The test tray according to claim 1, wherein the tray body comprises a bottom plate and two side plates spaced apart from each other in the second direction, the side plates are movably connected to the bottom plate in the second direction, and the compressing body is disposed on the side plate.

4. The test tray according to claim 3, wherein each of the side plates is provided with a first strip-shaped hole in the first direction;
the tray body further comprises an adjusting member, two ends of the adjusting member respectively pass through the first strip-shaped holes and are fixed to the side plates, and the clamp assembly is connected to the adjusting member.

5. The test tray according to claim 4, wherein the adjusting member comprises:
an adjusting rod, wherein two ends of the adjusting rod respectively pass through the first strip-shaped holes;
a fixing post, sleeving an outer periphery of the adjusting rod, wherein the fixing post is located on a side, facing the compressing body, of the side plate;
a locking member, configured to lock the adjusting rod to the side plate, wherein the locking member is located on a side, facing away from the compressing body, of the side plate; and
an equal-height post, wherein two ends of the equal-height post in the second direction abut against the two side plates, respectively.

6. The test tray according to claim 4, wherein the clamp assembly comprises two battery brackets spaced apart from each other in the second direction, and the two battery brackets are movably connected to the adjusting member in the second direction.

7. The test tray according to claim 6, wherein each of the battery brackets comprises:
a plate body, provided with a clearance groove;
a hook part, disposed on the plate body, wherein the hook part is connected to the adjusting member; and
an elastic part, connected to the plate body, wherein the elastic part is configured to abut against the adjusting member and is located in the clearance groove.

8. The test tray according to claim 3, wherein the side plate comprises a side plate body and a first protruding part, the first protruding part is provided in a protruding manner from the side plate body along a third direction, and the first protruding part and the side plate body define, in an enclosing manner, a first groove, the third direction intersecting with the first direction and the second direction;
the bottom plate comprises a bottom plate body and a second protruding part, the second protruding part is provided in a protruding manner relative to the bottom plate body in the second direction, the second protruding part and the bottom plate body define, in an enclosing manner, a second groove, the first protruding part is inserted into the second groove, and the second protruding part is inserted into the first groove.

9. The test tray according to claim 3, wherein the bottom plate is provided with a second strip-shaped hole extending in the second direction, and the side plate is fixed to the bottom plate through the second strip-shaped hole.

10. The test tray according to claim 3, wherein the bottom plate is further provided with a third strip-shaped hole extending in the second direction, and the clamp assembly is fixed to the bottom plate through the third strip-shaped hole.

11. The test tray according to any one of claims 1 to 10, wherein the tray body further comprises an elevation part, the elevation part comprises a plurality of cushion blocks sequentially arranged along a third direction, and the cushion blocks are configured to support the battery cell, the third direction intersecting with the first direction and the second direction.

12. The test tray according to claim 11, wherein the clamp assembly is provided with a mounting groove, and an end portion, in the first direction, of the elevation part is fixed in the mounting groove.

13. The test tray according to claim 12, wherein the tray body further comprises an elevation post, the clamp assembly is provided with a fixing hole for the elevation post to pass through, and the elevation post is configured to support the elevation part.

14. The test tray according to any one of claims 1 to 10, wherein the tray body further comprises a limiting block disposed on the compressing body, and the clamp assembly is fixed to the compressing body by the limiting block.

15. The test tray according to claim 14, wherein the clamp assembly is provided with a plurality of first limiting holes in the first direction, and the limiting block is provided with second limiting holes corresponding to the first limiting holes.

16. A battery production device, comprising the test tray according to any one of claims 1 to 15.
